# EUROPEAN PATENT SPECIFICATION

(11) **EP 2 096 766 B1**
(45) Date of publication and mention of the grant of the patent: **17.08.2016**
(21) Application number: 07832923.2
(22) Date of filing: 03.12.2007
(51) Int. Cl.: H04B 1/44, H03H 9/72

(54) **HIGH-FREQUENCY SWITCH CIRCUIT**
HOCHFREQUENZ-SCHALTNETZWERK
CIRCUIT DE COMMUTATION HAUTE FRÉQUENCE

(30) Priority: 21.12.2006 JP 2006345058
(43) Date of publication of application: 02.09.2009
(73) Proprietor: Murata Manufacturing Co. Ltd., Nagaokakyo-shi, Kyoto 617-8555 (JP)
(72) Inventor: FURUTANI, Koji, Nagaokakyo-shi, Kyoto-fu 617-8555 (JP)
(74) Representative: Schenk, Markus
(86) International application number: PCT/JP2007/073303
(87) International publication number: WO 2008/075551

(56) References cited:
- WO-A1-01/69807
- WO-A1-2006/057173
- JP-A- 08 330 930
- JP-A- 2001 189 605
- JP-A- 2003 133 882
- JP-A- 2005 020 140
- JP-A- 2005 045 345
- JP-A- 2006 129 419
- JP-A- 2006 157 423

## Description

### Technical Field

The present invention relates to high-frequency switching circuits and, in particular, to a high-frequency switching circuit including a high-frequency switch that includes a field-effect transistor (FET) switching element.

### Background Art

Patent Document 1 discloses a high-frequency switching circuit including a high-frequency switch that includes an FET switching element and that selectively connects between a common input/output terminal and one of a plurality of input/output terminals.

Fig. 1 is a circuit diagram of a high-frequency switching circuit illustrated in Patent Document 1. The high-frequency switching circuit 14 includes an antenna terminal ANT for connection to an antenna, a reception-signal output terminal RX for connection to a receiving circuit, a transmission-signal input terminal TX for connection to a transmitting circuit, and a high-frequency switch 12 and is a circuit for switching between a transmission signal and a reception signal.

Matching circuits M1, M2, and M3 are disposed between the antenna terminal ANT and the high-frequency switch 12, between the reception-signal output terminal RX and the high-frequency switch 12, and between the transmission-signal input terminal TX and the high-frequency switch 12, respectively. The matching circuits M1, M2, and M3 perform impedance matching between the respective terminals and the high-frequency switch 12.

The high-frequency switch 12 is composed of a semiconductor chip made of, for example, gallium arsenide (GaAs). The chip is bonded to each of the terminals with bonding wire (gold wire). Each of the matching circuits M1, M2, and M3 is designed in consideration of an electric inductance in the bonding wire.

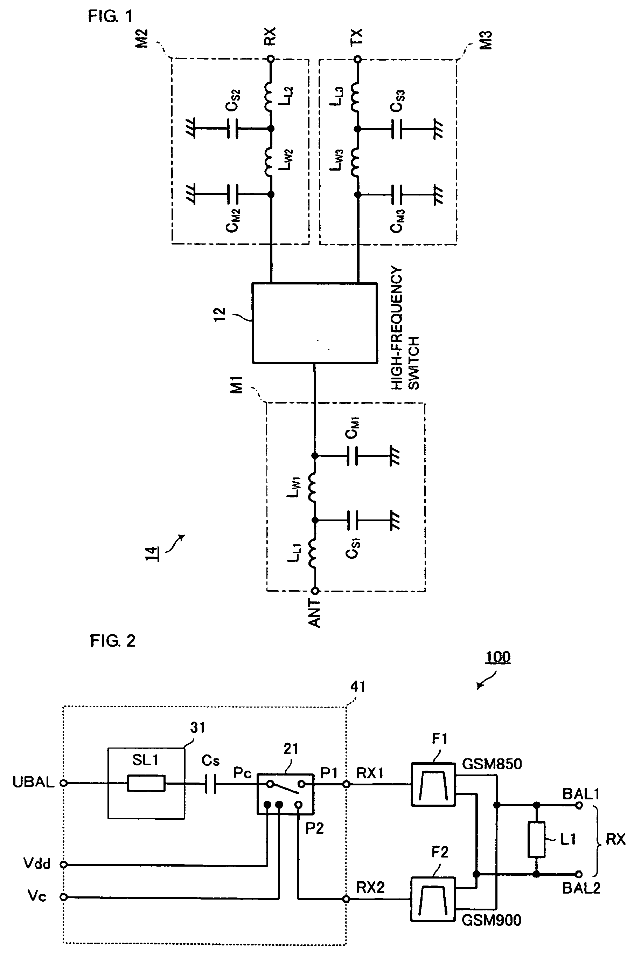

In the matching circuit M1 illustrated in Fig. 1, an inductor LL1 is the one in which an inductance being a lead to the antenna terminal ANT is represented by a symbol, a capacitor CS1 is the one in which a stray capacitance between the lead of the antenna terminal ANT and the ground is represented by a symbol, and an inductor LW1 is the one in which a bonding-wire inductance is represented by a symbol. A bulk capacitor CM1 is a metal-insulator-metal (MIM) capacitor.

Similarly, the matching circuits M2 and M3 include inductances LL2 and LL3 being lead components, stray capacitances CS2 and CS3 between the leads of the respective terminals and the ground, bonding-wire inductances LW2 and LW3, and MIM capacitors CM2 and CM3, respectively.

[Patent Document 1] Japanese Unexamined Patent Application Publication No. 10-93302

However, to meet a requirement for miniaturization of a high-frequency switching circuit module, it is necessary to reduce the size of a high-frequency switch, and in order to reduce its footprint, flip-chip mounting using bump connection is also necessary.

The inductance of the bump portion in the above flip-chip mounting is significantly smaller than that in wire bonding. Thus, for the flip-chip mounting, imperfect matching occurs, and an extra line and chip inductor for achieving matching for each terminal is needed.

JP 2006-129419 A describes a high-frequency switching circuit having two or more high-frequency switches provided correspondingly to a plurality of communication systems having mutually different frequency bands; and a control circuit adapted to control the switching of the two or more high-frequency switches, in which a common antenna terminal and further common terminals of the respective high-frequency switches 2 are connected via a matching circuit.

JP 2005-020140 A describes an antenna switch module having a common matching circuit commonly working between an antenna and the high frequency switch.

JP 2003-133882 A describes an impedance matching element having ground electrodes and lines for inductors formed on dielectric substrates laminated together.

JP 08-330930 A describes a semiconductor device having a through FET on a signal transmission line of a transmitting switch circuit which is placed between a transmitting signal input terminal and an antenna terminal. A shunt FET is provided on a branch line which branches out to the ground from a shunt junction point. In a receiving switch circuit placed between the terminal and a receiving terminal, a signal transmission line and a branch line are provided with a through FET and a shunt FET respectively. Impedance converter circuits are placed between the terminals and switch circuits to reduce the impedances to be applied into both switch circuits.

WO 2006/057173 A1 describes a FET switch formed by a FET selectively which connects an antenna I/O port to one of a first port connected to a transmission signal input terminal and a ports connected to two reception signal output terminals, respectively. A phase setting element connected to the first port.

JP 2001-189605 A describes a ceramic laminated RF device having at least one or two high frequency filters, and provided with a low temperature sintered ceramic laminate.

WO 01/69807 A1 describes a high-frequency module connected to a transmitting circuit, a receiving circuit and an antenna. The module comprises a first phase-shift circuit and a high-frequency amplifier provided between the antenna and the transmitting circuit. The high-frequency amplifier and the first phase-shift circuit are integrated into a module composed of a plurality of dielectric layers.

JP 2005-045345 A describes a high frequency module provided with a ceramic multilayer board provided with a 2-stage down-cavity; an antenna switch mounted in the down-cavity; a reception side filter, a transmission side filter, and a matching circuit component mounted on an upper side of the ceramic multilayer board.

JP 2006-157423 A describes a high frequency switch comprising inductors and a FET on a transmission path; and an FET, a DC cut capacitor and an inductor provided on a shunt path connecting this transmission path and the ground. The input/output impedance of a circuit, consisting of the inductors and the FET in an off state is configured so as to match the characteristic impedance of the transmission path.

### Summary of the Invention

It is an object of the present invention to provide a high-frequency switching circuit that has a small overall size and achieves impedance matching for each terminal.

This object is achieved by a high-frequency switching circuit module according to claim 1.

To solve the above problems, the high-frequency switching circuit according to the present invention is configured as follows:
(1) A high-frequency switching circuit comprises a high-frequency switch that includes a field-effect transistor (FET) switching element and that selectively connects between a common input/output terminal and one of a plurality of input/output terminals.
   The high-frequency switching circuit comprises a matching circuit, the matching circuit being disposed between the common input/output terminal and a circuit connected to the common input/output terminal and being not disposed between the plurality of input/output terminals and a circuit connected to each of the plurality of input/output terminals.
(2) The high-frequency switch comprises a semiconductor chip and is disposed on at least one of major surfaces of a multilayer substrate by flip-chip mounting, the matching circuit includes an inductor, and the inductor is formed on a first one of the major surfaces of the multilayer substrate or inside the multilayer substrate.
(3) The high-frequency switch comprises a semiconductor chip and is disposed on at least one of major surfaces of a multilayer substrate by flip-chip mounting, the matching circuit includes a chip inductor, the chip inductor is formed on a first one of the major surfaces of the multilayer substrate or inside the multilayer substrate.
(4) A cavity is formed in a second one of the major surfaces of the multilayer substrate, and the semiconductor chip is arranged in the cavity.
(5) The matching circuit is configured to correct a capacity component of the switching element being in an off state.
(6) The circuit connected to at least one of the plurality of input/output terminals comprises a surface-acoustic-wave (SAW) filter.

### Advantages

(1) The matching circuit is disposed between the common input/output terminal and the circuit connected to the common input/output terminal and is not disposed between the plurality of input/output terminals and the circuit connected to each of the plurality of input/output terminals. Accordingly, as described below, impedance matching between the common input/output terminal and all of the other input/output terminals can be achieved, the high-frequency switch can be mounted not by wire bonding, and its size can be reduced. Because the matching circuit is provided to only the common input/output terminal, the size can be further reduced correspondingly, and insertion loss can also be reduced.
(2) The high-frequency switch comprising the semiconductor chip is disposed on at least one of the major surfaces of the multilayer substrate by flip-chip mounting, and the inductor is disposed on the multilayer substrate being a mounting board for the high-frequency switch (semiconductor chip). Accordingly, the overall size can be reduced.
(3) The high-frequency switch comprising the semiconductor chip is disposed on at least one of the major surfaces of the multilayer substrate by flip-chip mounting, and the chip inductor being the matching circuit is mounted on the first one of the major surfaces of the multilayer substrate. Accordingly, a case where an inductor having a large inductance value is needed can be supported, and the design freedom for the matching circuit can be increased.
(4) The cavity is formed in the second one of the major surfaces of the multilayer substrate, and the semiconductor chip being the high-frequency switch is arranged in the cavity. Accordingly, the high-frequency switching circuit having a reduced overall profile can be configured.
(5) The matching circuit acts with the capacity of the switching element being in an off state and corrects the capacity component. Accordingly, the impedance between the common input/output terminal and a selected input/output terminal can be matched to the normal impedance, and the high-frequency switching circuit achieving impedance matching can be configured.
(6) The circuit connected to the at least one of the plurality of input/output terminals comprises the SAW filter. Accordingly, in designing the matching circuit, impedance mismatch caused by an electric capacitance in the SAW filter can also be cancelled. This obviates the necessity to provide the SAW filter in itself with the matching circuit. The high-frequency circuit including the SAW filter can have a small overall size, and insertion loss can be reduced. Brief Description of Drawings

[Fig. 1] Fig. 1 illustrates a configuration of a high-frequency switching circuit illustrated in Patent Document 1.
[Fig. 2] Fig. 2 is a circuit diagram of a high-frequency switching circuit module according to a first embodiment.
[Fig. 3] Fig. 3 is a circuit diagram of a high-frequency switch used in the high-frequency switching circuit module.
[Fig. 4] Fig. 4 illustrates an equivalent circuit diagram of the high-frequency switch and a matching circuit.
[Fig. 5] Fig. 5 illustrates examples of electrode patterns disposed on dielectric layers of a multilayer substrate of the high-frequency switching circuit module according to the first embodiment.
[Fig. 6] Fig. 6 illustrates examples of electrode patterns disposed on dielectric layers of a multilayer substrate of the high-frequency switching circuit module according to the first embodiment.
[Fig. 7] Fig. 7 illustrates a configuration of a high-frequency switching circuit module according to a second embodiment.
[Fig. 8] Fig. 8 illustrates examples of electrode patterns disposed on dielectric layers of a multilayer substrate of the high-frequency switching circuit module according to the second embodiment.
[Fig. 9] Fig. 9 illustrates examples of electrode patterns disposed on dielectric layers of a multilayer substrate of the high-frequency switching circuit module according to the second embodiment.

### Reference Numerals

- 31: matching circuit
- 21, 22: high-frequency switch
- SL1: matching strip line
- F1-F5: SAW filter
- L1: inductor
- 41, 42: high-frequency switching circuit
- Pc: common input/output terminal
- P1, P2: input/output terminal
- RX, RX1, RX2: reception-signal output port
- 100: switching circuit module
- 101: high-frequency switching circuit module

### Best Mode for Carrying Out the Invention

### «First Embodiment»

A configuration of a dual-band switching circuit module including a high-frequency switching circuit according to a first embodiment is described with reference to Figs. 2 to 6.

Fig. 2 is a circuit diagram of a switching circuit module 100 including a high-frequency switching circuit according to the first embodiment. The switching circuit module is a circuit that switches between GSM-850/GSM-900 reception signals from an unbalanced terminal UBAL and outputs a selected signal in accordance with a frequency band. The switching circuit module 100 includes a high-frequency switching circuit 41, surface-acoustic-wave (SAW) filters F1 and F2, and an inductor L1.

The high-frequency switching circuit 41 includes a high-frequency switch 21 and a matching circuit 31. The high-frequency switch 21 includes a field-effect transistor (FET) switching element and selectively connects between a common input/output terminal Pc and one of two input/output terminals P1 and P2. The matching circuit 31 includes a matching strip line SL1 and is connected between the common input/output terminal Pc of the high-frequency switch 21 and the unbalanced terminal UBAL.

A first reception-signal output port RX1 of the high-frequency switching circuit 41 (the first input/output terminal P1 of the high-frequency switch 21) is connected to an unbalanced terminal of the first SAW filter F1. The first SAW filter F1 allows a GSM-850 reception signal to pass therethrough. Similarly, a second reception-signal output port RX2 (the second input/output terminal P2 of the high-frequency switch 21) is connected to an unbalanced terminal of the second SAW filter F2. The second SAW filter F2 allows a GSM-900 reception signal to pass therethrough.

A balanced terminal of the first SAW filter F1 and that of the second SAW filter F2 are mutually connected, and an inductor L1 serving as a balance coil is connected between balanced terminals BAL1 and BAL2.

A power supply voltage input into a power-supply terminal Vdd of the high-frequency switching circuit 41 is applied to the high-frequency switch 21. A control voltage input into a control terminal Vc is applied to the high-frequency switch 21.

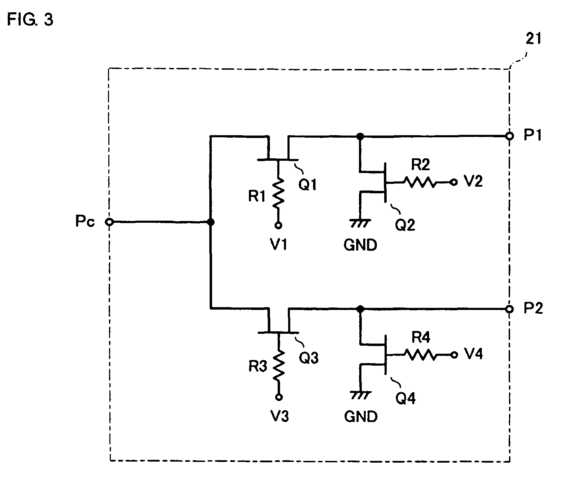

Fig. 3 is a circuit diagram that illustrates a specific configuration of the high-frequency switch 21 illustrated in Fig. 2. An FET Q1 is connected in series and an FET Q2 is connected in shunt between the common input/output terminal Pc and the first input/output terminal P1. The FET Q1 and Q2 have gates to which control voltages V1 and V2 are applied through resistors R1 and R2, respectively. Similarly, an FET Q3 is connected in series and an FET Q4 is connected in shunt between the common input/output terminal Pc and the second input/output terminal P2. The FET Q3 and Q4 have gates to which control voltages V3 and V4 are applied through resistors R3 and R4, respectively.

In Fig. 3, the control voltages V1 to V4 are applied such that, when the FET Q1 and Q4 are in an on state, the FET Q2 and Q3 are in an off state, and in contrast, when the FET Q2 and Q3 are in an on state, the FET Q1 and Q4 are in an off state.

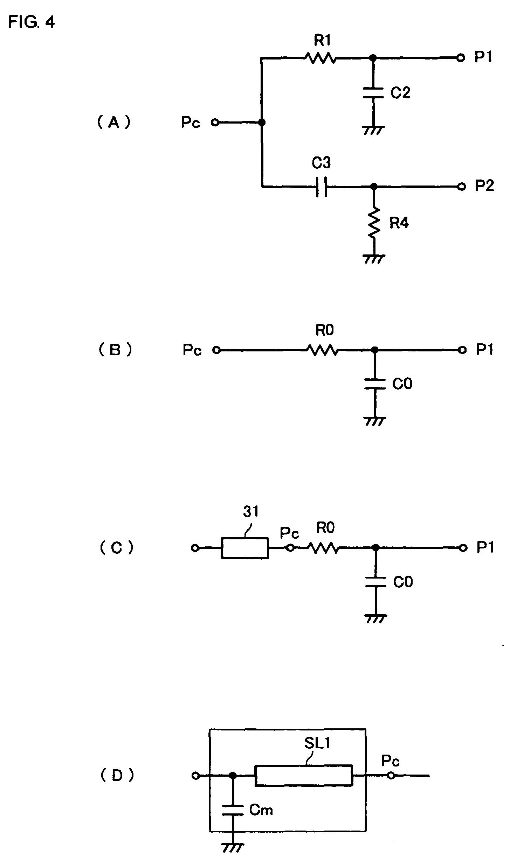

Fig. 4 illustrates equivalent circuit diagrams when the FET Q1 and Q4 are in an on state and the FET Q2 and Q3 are in an off state in the high-frequency switch 21 illustrated in Fig. 3. The FETs in an on state are represented by the resistors R1 and R4, and the FETs in an off state are represented by capacitors C2 and C3. Accordingly, this state indicates a parallel circuit of a series circuit of R1 and C2 and a series circuit of C3 and R4 and can be represented by a circuit constituting a series circuit of a resistor R0 and a capacitor C0 between the common input/output terminal Pc and the ground, as illustrated in Fig. 4(B).

The same applies to a situation where the FET Q1 and Q4 illustrated in Fig. 3 are in an off state and the FET Q2 and Q3 are in an on state.

The existence of an input/output terminal that is not selected allows the non-selected input/output terminal (port) to act as a capacitor, thus causing a displacement of the impedance between the common input/output terminal and a selected input/output terminal from a normal impedance (50Ω). To correct the capacitance C0 disposed in parallel between the line and the ground in this circuit and make the impedance viewed from the common input/output terminal Pc to the high-frequency switch 21 equal to the normal impedance, the matching circuit 31 is provided, as illustrated in Fig. 4(C). The matching circuit 31 illustrated in Fig. 2 is a circuit determined in this way.

The above matching circuit may also include the matching strip line SL1 and a capacitor Cm connected in shunt with the signal line. The provision of the capacitor Cm allows the impedance to be determined by the inductance of the strip line SL1 and the capacitance of the capacitor Cm. Accordingly, the design freedom for the matching circuit can be improved.

Determining the impedance of the matching circuit 31 so as to cancel an impedance mismatch caused by an electric capacitance in the SAW filters F1 and F2 in designing the high-frequency switch 21 obviates the necessity to provide each of the SAW filters F1 and F2 in itself with the matching circuit. This leads to a small overall size of the high-frequency circuit including the SAW filters and a reduction in insertion loss.

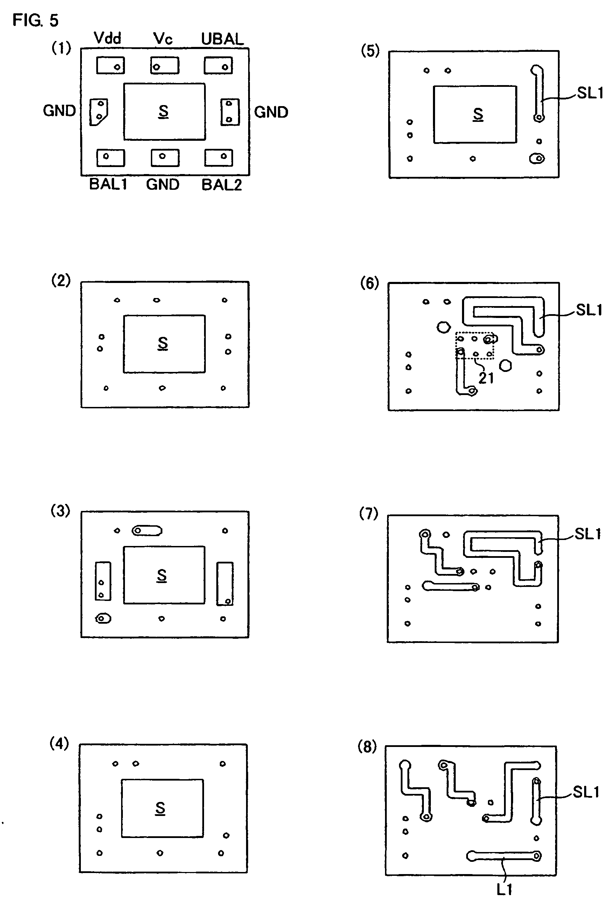

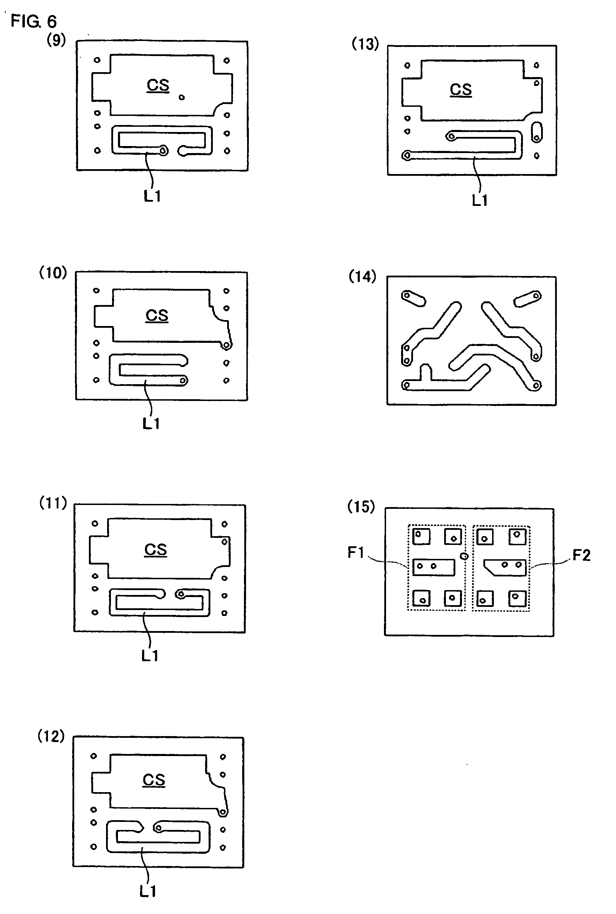

Figs. 5 and 6 illustrate specific examples of electrode patterns disposed on dielectric layers when the switching circuit module illustrated in Fig. 2 is formed in a multilayer substrate.

In Figs. 5 and 6, (1) to (15) represent dielectric layers of the multilayer substrate in sequence. (1) in Fig. 5 indicates the lowest dielectric layer, and (15) in Fig. 6 indicates the uppermost dielectric layer. Figs. 5 and 6 illustrate the dielectric layers (1) to (15) viewed from a bottom side (a side facing a mounting board). The electrode pattern illustrated in (15) in Fig. 6 is formed at an upper surface side of the dielectric layer.

The terminals (GND, Vdd, Vc, UBAL, BAL1, BAL2) for use in mounting on a mounting board are formed on the lowest dielectric layer (1). These terminals correspond to the terminal having the same names illustrated in Fig. 2.

Each of the dielectric layers (1) to (5) has a cavity S. The high-frequency switch 21 is mounted at the front side of the dielectric layer (6) not by wire bonding but by flip-chip bonding. The high-frequency switch 21 is thus arranged in the cavity.

Each of the dielectric layers (5) to (8) has the matching strip line SL1. Each of the dielectric layers (9) to (13) has an electrode of the capacitor Cs.

Each of the dielectric layers (8) to (13) has the inductor L1 being a balance coil.

The dielectric layer (15) has the two SAW filters F1 and F2 at its front side.

In such a way, the switching circuit module illustrated in Fig. 2 is formed on the multilayer substrate, and the dual-band switching circuit module for GSM-850 and GSM-900 is configured.

In the first embodiment, the high-frequency switch 21 is mounted in the cavity formed in the front side of the multilayer substrate by flip-chip bonding. However, the high-frequency switch may also be arranged in a cavity formed in the underside of the multilayer substrate.

### <<Second Embodiment>>

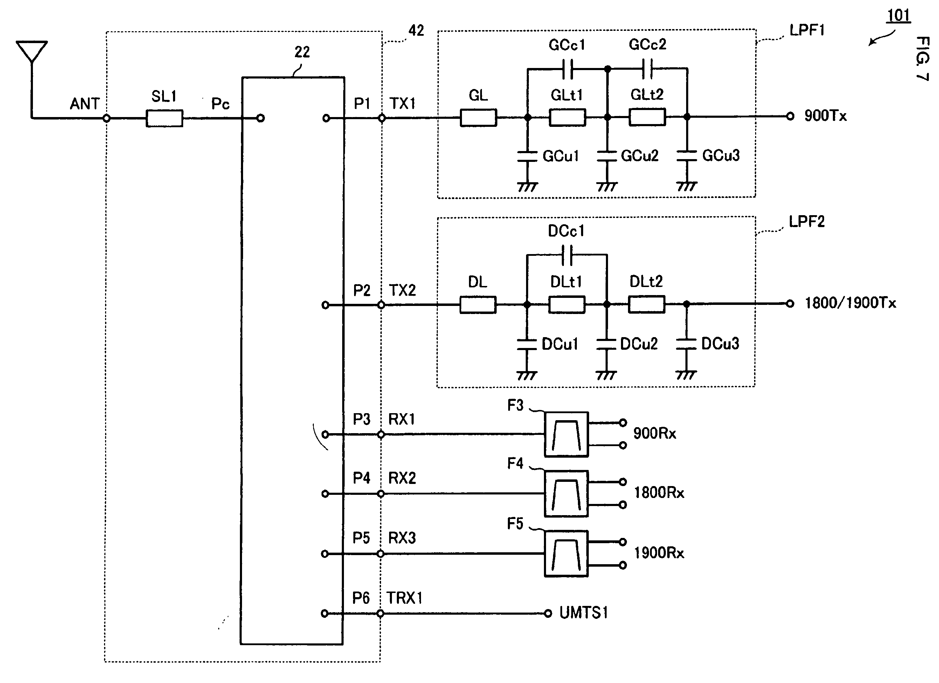

A configuration of a triple-band switchplexer including a high-frequency switching circuit according to a second embodiment is described with reference to Figs. 7 to 9.

Fig. 7 is a circuit diagram of a switchplexer 101 according to the second embodiment. The switchplexer 101 includes a high-frequency switching circuit 42, low-pass filters LPF1 and LPF2, and SAW filters F3, F4, and F5.

The high-frequency switching circuit 42 includes a high-frequency switch 22 and a strip line SL1 serving as a matching circuit. The high-frequency switch 22 selectively connects between a common input/output terminal Pc and any one of a plurality of input/output terminals P1 to P6. A control terminal and a power-supply terminal for performing this switching are omitted in Fig. 7. The high-frequency switch 22 is provided with the matching strip line SL1 disposed between the common input/output terminal Pc and an antenna terminal ANT of the high-frequency switching circuit 42.

The low-pass filter LPF1 allows a signal at a GSM-900 transmission-signal frequency band among input signals from a GSM-900 transmission-signal input terminal 900Tx to pass therethrough. Similarly, the low-pass filter LPF2 allows a signal at a GSM-1800/1900 transmission-signal frequency band among input signals from a GSM-1800/1900 transmission-signal input terminal 1800/1900Tx to pass therethrough.

The low-pass filter LPF1 includes strip lines GL, GLt1, and GLt2 and capacitors GCc1, GCc2, GCu1, GCu2, and GCu3. Similarly, the low-pass filter LPF2 includes strip lines DL, DLt1, and DLt2 and capacitors DCc1, DCc2, DCu1, DGCu2, and DCu3.

The SAW filter F3 allows a signal at a GSM-900 reception-signal frequency band with respect to signals from a reception-signal output port RX1 of the high-frequency switching circuit 42 to pass therethrough. The SAW filter F4 allows a signal at a GSM-1800 reception-signal frequency band with respect to signals from a reception-signal output port RX2 of the high-frequency switching circuit 42 to pass therethrough. Similarly, the SAW filter F5 allows a signal at a GSM-1900 reception-signal frequency band with respect to signals from a reception-signal output port RX3 of the high-frequency switching circuit 42 to pass therethrough.

A transmission and reception signal port TRX1 of the high-frequency switching circuit 42 is connected to a UMTS1 circuit.

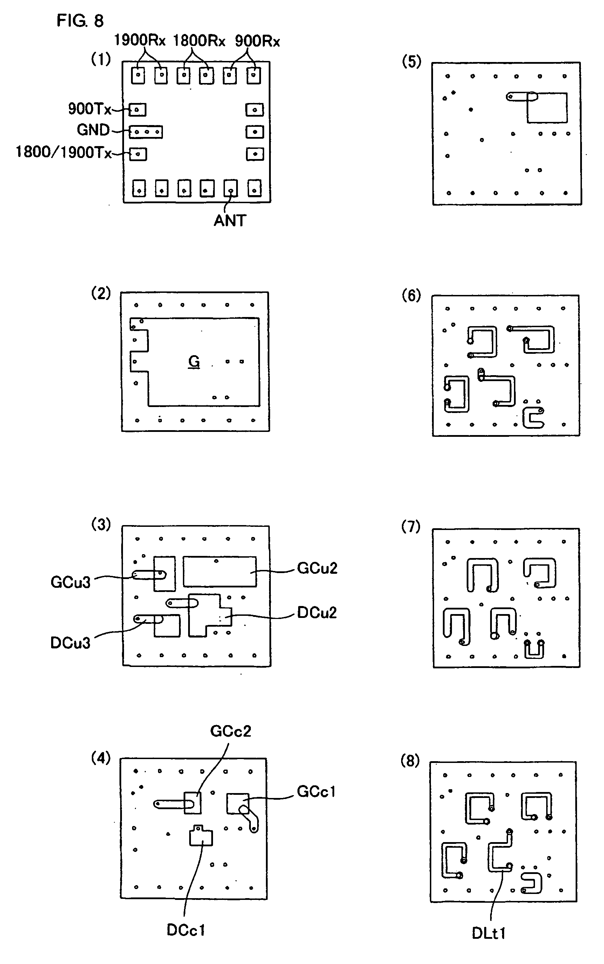

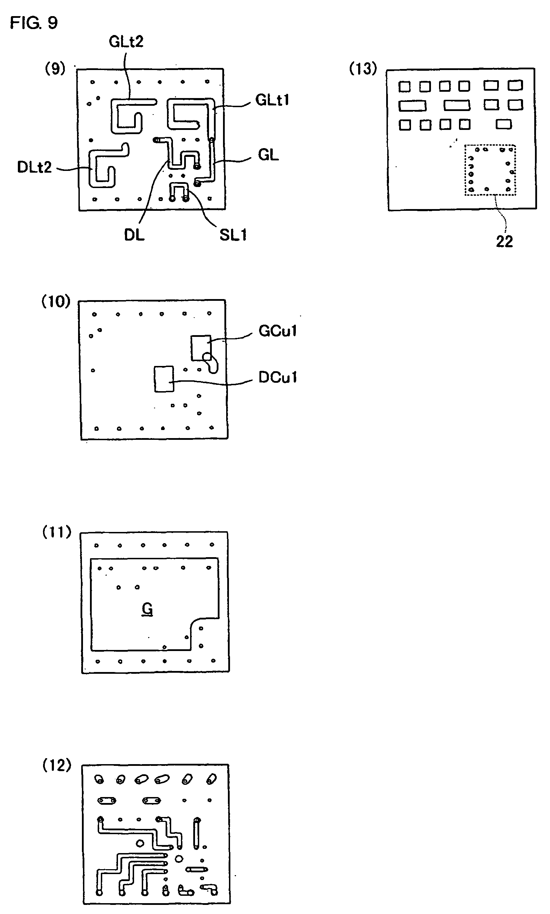

Figs. 8 and 9 illustrate specific examples of electrode patterns disposed on dielectric layers when the switchplexer illustrated in Fig. 7 is formed in a multilayer substrate.

In Figs. 8 and 9, (1) to (13) represent dielectric layers of the multilayer substrate in sequence. (1) in Fig. 8 indicates the lowest dielectric layer, and (13) in Fig. 9 indicates the uppermost dielectric layer. Figs. 8 and 9 illustrate the dielectric layers (1) to (13) viewed from a bottom side (a side facing a mounting board). The electrode pattern illustrated in (13) in Fig. 9 is formed at an upper surface side of the dielectric layer.

The terminals (GND, 1900Rx, 1800Rx, 900Rx, 1800/1900Tx, 900Tx, ANT, and the like) for use in mounting on a mounting board are formed on the lowest dielectric layer (1). These terminals correspond to the terminal having the same names illustrated in Fig. 7.

Each of the dielectric layers (2) and (11) has a ground electrode G.

Each of the dielectric layers (3), (4), and (10) has the capacitor electrodes GCu2, GCu3, DCu2, DCu3, GCc1, GCc2, DCc1, GCu1, and DCu1.

Each of the dielectric layers (6) to (9) has the strip lines DLt1, GLt1, GLt2, DLt2, GL, and DL.

The dielectric layer (9) has the matching strip line SL1.

The high-frequency switch 22 is mounted at the front side of the dielectric layer (13) not by wire bonding but by flip-chip bonding.

In such a way, the switchplexer illustrated in Fig. 7 is disposed in the multilayer substrate, and the triple-band switchplexer for GSM-900/GSM-1800/GSM-1900 is configured.

## Claims

1. A high-frequency switching circuit module comprising:
a common input/output terminal (UBAL);
a plurality of input/output terminals (P1, P2);
a high-frequency switch (21) that includes a field-effect transistor (FET) switching element (Q1-Q4) and that selectively connects between the common input/output terminal (UBAL) and one of the plurality of input/output terminals (P1, P2);
a multilayer substrate including a plurality of stacked dielectric layers (1-15); and
a matching circuit (31),
wherein the high-frequency switch (21) comprises a semiconductor chip and is disposed on at least one of major surfaces of a multilayer substrate by flip-chip mounting via a bump portion having an inductance,
wherein the matching circuit (31) is disposed between the common input/output terminal (UBAL) and a circuit connected to the common input/output terminal (UBAL) and is not disposed between the plurality of input/output terminals (P1, P2) and a circuit (F1, F2) connected to each of the plurality of input/output terminals (p1, P2),
wherein the matching circuit (31) includes an inductor (SL1) formed on a first one of the major surfaces of the multilayer substrate or inside the multilayer substrate, and
wherein an impedance of the matching circuit (31) is set to correct an electrical capacitance generated at the input/output terminals of the switching element (21) in an off-state.

2. The high-frequency switching circuit module according to Claim 1, wherein the inductor (SL1) of the matching circuit (31) is arranged in series between the common input/output terminal (UBAL) and the circuit connected to the common input/output terminal (UBAL).

3. The high-frequency switching circuit module according to Claim 2, wherein the matching circuit (31) further includes a capacitor (Cm) connected in shunt.

4. The high-frequency switching circuit module according to any one of Claims 1 to 3, wherein the matching circuit (31) includes a chip inductor.

5. The high-frequency switching circuit module according to any one of Claims 1 to 4, wherein a cavity (S) is formed in a second one of the major surfaces of the multilayer substrate, and the semiconductor chip is arranged in the cavity (S).

6. The high-frequency switching circuit module according to any one of Claims 1 to 5, wherein the circuit connected to at least one of the plurality of input/output terminals (P1, P2) comprises a surface-acoustic-wave (SAW) filter (F1, F2).

## Patentansprüche

1. Ein Hochfrequenz-Umschaltschaltungsmodul, das folgende Merkmale aufweist:
einen gemeinsamen Eingangs-/Ausgangsanschluss (UBAL);
eine Mehrzahl von Eingangs-/Ausgangsanschlüssen (P1, P2);
einen Hochfrequenzschalter (21), der ein Feldeffekttransistor(FET)-Umschaltelement (Q1-Q4) umfasst und der zwischen dem gemeinsamen Eingangs-/Ausgangsanschluss (UBAL) und einem der Mehrzahl von Eingangs-/Ausgangsanschlüssen (P1, P2) selektiv verbindet;
ein Mehrschichtsubstrat, das eine Mehrzahl von gestapelten dielektrischen Schichten (1-15) umfasst; und
eine Anpassungsschaltung (31),
wobei der Hochfrequenzschalter (21) einen Halbleiterchip aufweist und zumindest auf einer der Hauptoberflächen eines Mehrschichtsubstrats durch Flip-Chip-Befestigung über einen Bump-Abschnitt mit einer Induktivität angeordnet ist,
wobei die Anpassungsschaltung (31) zwischen dem gemeinsamen Eingangs-/Ausgangsanschluss (UBAL) und einer Schaltung, die mit dem gemeinsamen Eingangs-/Ausgangsanschluss (UBAL) verbunden ist, angeordnet ist und nicht zwischen der Mehrzahl von Eingangs-/Ausgangsanschlüssen (P1, P2) und einer Schaltung (F1, F2), die mit jedem der Mehrzahl von Eingangs-/Ausgangsanschlüssen (p1, P2) verbunden ist, angeordnet ist,
wobei die Anpassungsschaltung (31) einen Induktor (SL1) umfasst, der auf einer ersten der Hauptoberflächen des Mehrschichtsubstrats oder innerhalb des Mehrschichtsubstrats gebildet ist, und
wobei eine Impedanz der Anpassungsschaltung (31) eingestellt ist, eine elektrische Kapazität zu korrigieren, die an den Eingangs-/Ausgangsanschlüssen des Umschaltelements (21) in einem ausgeschalteten Zustand erzeugt wird.

2. Das Hochfrequenz-Umschaltschaltungsmodul gemäß Anspruch 1, bei dem der Induktor (SL1) der Anpassungsschaltung (31) zwischen dem gemeinsamen Eingangs-/Ausgangsanschluss (UBAL) und der Schaltung, die mit dem gemeinsamen Eingangs-/Ausgangsanschluss (UBAL) verbunden ist, in Reihe angeordnet ist.

3. Das Hochfrequenz-Umschaltschaltungsmodul gemäß Anspruch 2, bei dem die Anpassungsschaltung (31) ferner einen Kondensator (Cm) aufweist, der in Nebenschluss geschaltet ist.

4. Das Hochfrequenz-Umschaltschaltungsmodul gemäß einem der Ansprüche 1 bis 3, bei dem die Anpassungsschaltung (31) einen Chipinduktor umfasst.

5. Das Hochfrequenz-Umschaltschaltungsmodul gemäß einem der Ansprüche 1 bis 4, bei dem ein Hohlraum (S) in einer zweiten der Hauptoberflächen des Mehrschichtsubstrats gebildet ist und der Halbleiterchip in dem Hohlraum (S) angeordnet ist.

6. Das Hochfrequenz-Umschaltschaltungsmodul gemäß einem der Ansprüche 1 bis 5, bei dem die Schaltung, die mit zumindest einem der Mehrzahl von Eingangs-/Ausgangsanschlüssen (P1, P2) verbunden ist, ein Oberflächenwellen(SAW)-Filter (F1, F2) aufweist.

## Revendications

1. Module de circuit de commutation haute fréquence comportant :
une borne d'entrée/sortie commune (UBAL) ;
une pluralité de bornes d'entrée/sortie (P1, P2);
un commutateur haute fréquence (21) qui comprend un élément de commutation (Q1-Q4) à transistor à effet de champ (FET) et qui relie sélectivement la borne d'entrée/sortie commune (UBAL) et l'une de la pluralité de bornes d'entrée/sortie (P1, P2) ;
un substrat multicouche comportant une pluralité de couches diélectriques empilées (1-15) ; et
un circuit d'adaptation (31),
dans lequel le commutateur haute fréquence (21) comporte une puce semi-conductrice et est disposé sur au moins une des surfaces principales d'un substrat multicouche par montage puce retournée par l'intermédiaire d'une partie de bosse possédant une inductance,
dans lequel le circuit d'adaptation (31) est disposé entre la borne d'entrée/sortie commune (UBAL) et un circuit relié à la borne d'entrée/sortie commune (UBAL) et n'est pas disposé entre la pluralité de bornes d'entrée/sortie (P1, P2) et un circuit (F1, F2) relié à chacune de la pluralité de bornes d'entrée/sortie (P1, P2),
dans lequel le circuit d'adaptation (31) comprend un inducteur (SL1) formé sur une première des surfaces principales du substrat multicouche ou à l'intérieur du substrat multicouche, et
dans lequel une impédance du circuit d'adaptation (31) est déterminée pour corriger une capacité électrique générée aux bornes d'entrée/sortie de l'élément de commutation (21) dans un état hors tension.

2. Module de circuit de commutation haute fréquence selon la revendication 1, dans lequel l'inducteur (SL1) du circuit d'adaptation (31) est disposé en série entre la borne d'entrée/sortie commune (UBAL) et le circuit relié à la borne d'entrée/sortie commune (UBAL).

3. Module de circuit de commutation haute fréquence selon la revendication 2, dans lequel le circuit d'adaptation (31) comprend en outre un condensateur (Cm) relié en parallèle.

4. Module de circuit de commutation haute fréquence selon l'une quelconque des revendications 1 à 3, dans lequel le circuit d'adaptation (31) comprend un inducteur de puce.

5. Module de circuit de commutation haute fréquence selon l'une quelconque des revendications 1 à 4, dans lequel une cavité (S) est formée dans une seconde des surfaces principales du substrat multicouche, et la puce semi-conductrice est disposée dans la cavité (S).

6. Module de circuit de commutation haute fréquence selon l'une quelconque des revendications 1 à 5, dans lequel le circuit relié à au moins l'une de la pluralité de bornes d'entrée/sortie (P1, P2) comporte un filtre (S1, S2) à ondes acoustiques de surface (SAW).
